# EUROPEAN PATENT APPLICATION

(11) **EP 4 064 329 A2**
(43) Date of publication of application: **28.09.2022**
(21) Application number: 22164135.0
(22) Date of filing: 24.03.2022
(51) Int. Cl.: H01L 21/48, H01L 23/498

(54) **METHOD TO CONNECT POWER TERMINAL TO SUBSTRATE WITHIN SEMICONDUCTOR PACKAGE**

(30) Priority: 24.03.2021 US 202117211028
(71) Applicant: Littelfuse, Inc., Chicago, IL 60631 (US)
(72) Inventor: Arjmand, Elaheh, Chicago, 60631 (US); Seiroco, Hamilton, Chicago, 60631 (US); Spann, Thomas, Chicago, 60631 (US)
(74) Representative: Arnold & Siedsma

(57) **Abstract**

A method to connect power terminals to substrates within semiconductor packages is disclosed. The power terminal connection method minimally adapts the power terminal so that laser treatment can be used to connect the power terminal to the substrate. The power terminal may be adapted in a variety of ways, such that an interface between the power terminal and the substrate may be transformed (melted with consecutive rapid solidification) by the laser device, allowing the power terminal to be connected to the substrate.

## Description

### Field of the Disclosure

Embodiments of the present disclosure relate to power semiconductors and, more particularly, to a technique for connecting a power terminal to a substrate within a power module semiconductor package.

### Background

Power semiconductors are components used to convert energy from one form to another at various stages between the points of energy generation and energy consumption. A power semiconductor component can take the form of a discrete transistor, thyristor, diode, insulated gate bipolar transitor (IGBT), or metal oxide semiconductor field effect transitor (MOSFET). Or, for a higher level of current or integration, the component can take the form of a multi-chip module, which contains more than one of these chips or dies in a desired configuration or topology. Power semiconductors may be packaged in a variety of discrete and multi-chip module formats.

The semiconductor devices include power terminals, or conductive "legs", extending from the semiconductor packaging, for connection to printed circuit boards and other circuit elements. The power terminals for high power applications typically have a thickness of at least 0.8 mm and may be 2.0 mm or more. The power terminals may be connected to the semiconductor packaging using conventional technologies such as soldering, sintering, and welding, e.g., high-current pulse welding, and ultrasonic welding. However, ultrasonic welding is messy, as particles, whiskers, or debris-like particles are generated during the welding process. Further, the generated debris is electrically conductive and able to disturb the function of the power semiconductor unit and/or the substrate of the semiconductor packaging may be cracked or otherwise damaged during the ultrasonic welding process.

United States Patent No. 10,720,376 describes a method to connect terminals inside discrete packages using ultrasonic welding as well as laser welding to attach the leadframe to the Direct Copper Bonded (DCB) substrate. A disadvantage of this method is that, the thicker the leadframe, the more laser energy needed to make the leadframe to DCB connection. Further, for high power modules, the terminals may be much thicker than 1mm.

It is with respect to these and other considerations that the present improvements may be useful.

### Summary

This Summary is provided to introduce a selection of concepts in a simplified form that are further described below in the Detailed Description. This Summary is not intended to identify key or essential features of the claimed subject matter, nor is it intended as an aid in determining the scope of the claimed subject matter.

An exemplary embodiment of a laser bonding method in accordance with the present disclosure may include removing material from a first portion of a power terminal such that the first portion has a first dimension and a second portion of the power terminal has a second dimension, the first dimension being less than the second dimension, disposing the first portion over a substrate of a semiconductor device, activating a laser device in a way to implement energy into an interface between the first portion and the substrate, and connecting the first portion of the power terminal to the substrate.

An exemplary embodiment of a power semiconductor package in accordance with the present disclosure may include a substrate having an insulator material sandwiched between a first conducting material and a second conducting material, the substrate being disposed on a baseplate. The power semiconductor package also may include a power terminal located on the first conducting material. The power terminal has a first portion and a second portion. The first portion has a first dimension and the second portion has a second dimension. The first dimension is thinner than the second dimension and the first portion is adjacent to the first conducting material at an interface. The first portion and the first conducting material are transformed at the interface using a laser device. Once the transformed first portion and first conducting material solidify, an electrical connection is established between the first conducting material and the power terminal.

### Brief Description of the Drawings

**FIGs. 1-4** are diagrams illustrating power module semiconductor packages, in accordance with exemplary embodiments;
**FIG. 5** is a diagram illustrating a laser bonding method, in accordance with exemplary embodiments;
**FIGs. 6A-6F** are diagrams illustrating a laser bonding method, in accordance with exemplary embodiments;
**FIG. 7** is a diagram illustrating a laser bonding method, in accordance with exemplary embodiments; and
**FIG. 8** is a flow diagram illustrating the operations of a laser bonding method, in accordance with exemplary embodiments.

### Detailed Description

A method to connect power terminals to substrates within semiconductor packages is disclosed. The power terminal connection method minimally adapts the power terminal so that laser treatment can be used to weld the power terminal to the substrate. The power terminal may be adapted in a variety of ways, such that an interface between the power terminal and the substrate may be melted by the laser device, allowing the power terminal to be bonded to the substrate.

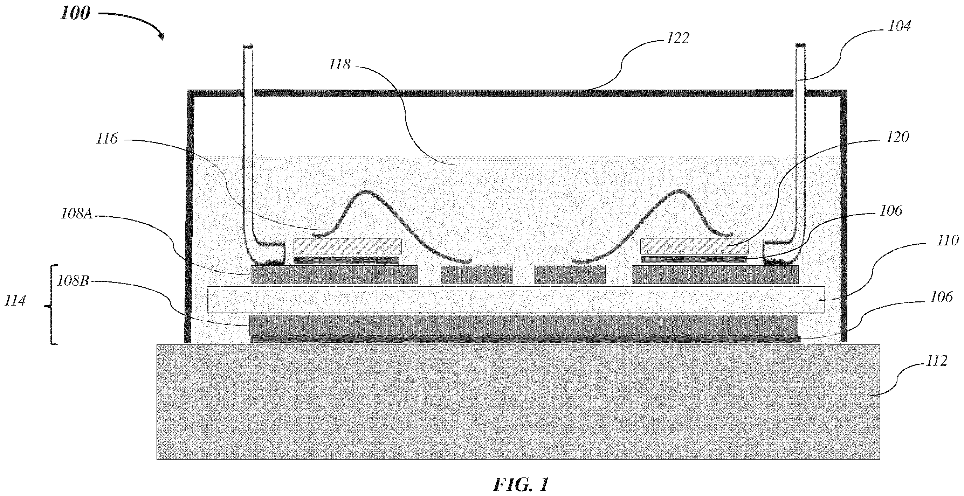

**FIGs. 1-4** are representative cross-sectional views of power semiconductor packages, according to exemplary embodiments. The power semiconductor package 100 illustrated in **FIG. 1** features a metal heatsink 112, which pulls heat away from the rest of the circuitry and forms the baseplate of the package. A substrate 114 is shown as a sandwich structure consisting of two conducting materials 108A and 108B (collectively, "conducting materials 108") covering an insulating material 110, such as ceramic. The substrate 114 is soldered or sintered to the metal heatsink 112 by use of a solder or sinter layer 106. Silicon or silicon-based chips or dies 120 are connected to the top metal circuit layer 108A of the substrate 114 by a solder or sinter layer 106. Metal wires, metal ribbons, metal clips 116, or combinations thereof, are connected to dies 120 and metal layer providing interconnections to the package. A contact element/terminal lead (referred to herein simply as "terminal" or "power terminal") 104 is also attached or added to the top metal circuit layer 108A of the substrate 114. An encapsulation layer 118 encases the circuit elements above the heatsink 112 and a packaging or housing 122 protects the elements from outside exposure, with only the contact element/terminal leads 104 being exposed. The packaging or housing 122 may be made of a plastic material.

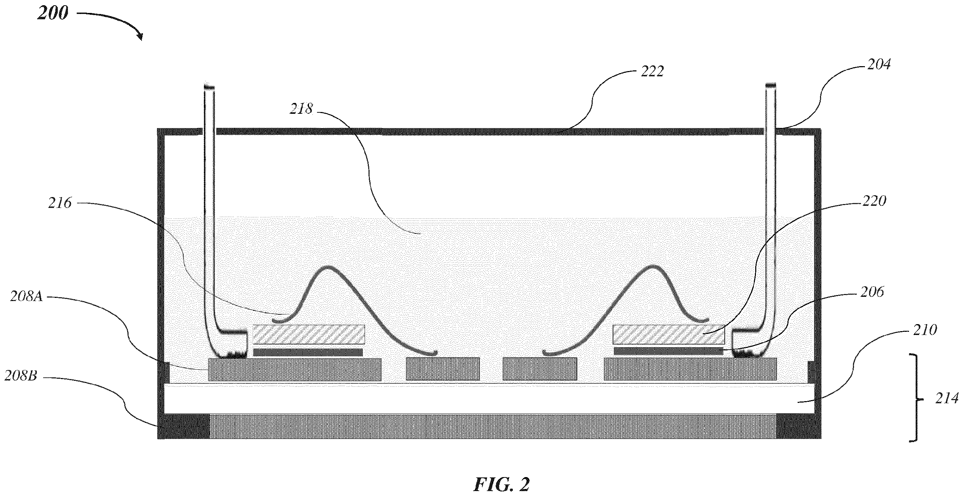

The power semiconductor package 200 illustrated in **FIG. 2** features many of the elements of power semiconductor package 100. A substrate 214 consisting of an insulator material 210, such as ceramic, sandwiched between two metal circuits 208A and 208B. Two or more silicon or silicon-based chips or dies 220 are disposed above the substrate 214. Terminals 204 are soldered or sintered onto the top layer 208A of the substrate 214. The package elements are encapsulated in an encapsulation layer 218 and also packaged into a package or housing 222, which may be plastic. Again, only the terminals 204 extend to outside the package or housing 222. The package 200 is an example of exposed DCB. An exposed DCB package has an interface that is physically in contact with a cooler. By contrast, a baseplate module has the baseplate with a DCB on top, where the baseplate is physically in contact with the cooler.

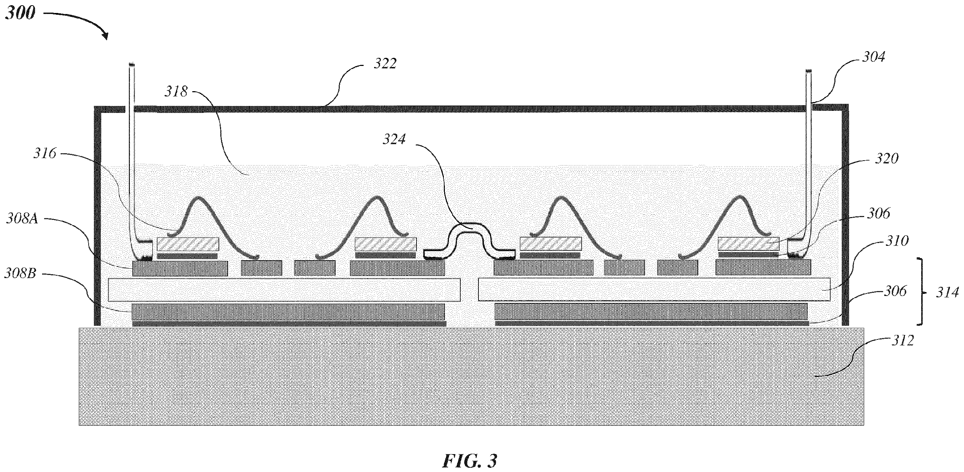

The power semiconductor package 300 illustrated in **FIG. 3** features both a heatsink 312 and a bridge clip 324. Substrates 314 feature metal circuits 308A, 308B covering a ceramic insulator 310. Each set of substrates 314 has disposed thereon two or more silicon or silicon-based chips or dies 320. The bridge clip 324 connects the substrates 314 and each substrate has attached by solder or sinter layer 306. Metal wires, metal ribbons, metal clips, or combinations thereof 316 connect between the chips/dies 320 and respective substrates 314. The package elements are enclosed in an encapsulation layer 318 and are contained within a housing/package 322, with only the terminals 304 being visible external to the package.

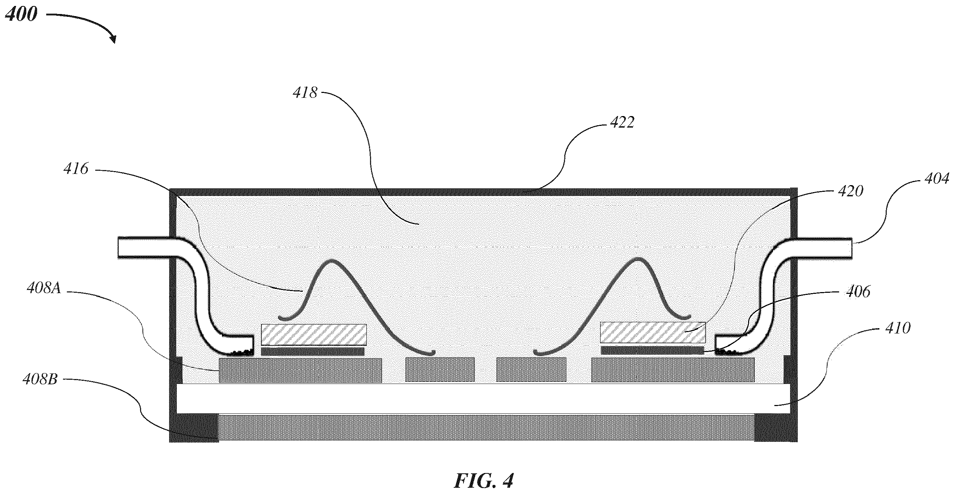

The discrete power semiconductor package 400 illustrated in **FIG. 4** features two or more contact element/terminal leads 404, metal wires, metal ribbons, metal clips, or combinations thereof 416, metal layers 408A and 408B (where the circuitry structure is on metal layer 408A), encapsulation material (transfer mold compound) 418, a soldering/sintering layer 406, and a semiconductor die/chip 420.

The power semiconductor packages 100, 200, 300, and 400 may be suitable for the laser bonding method described in more detail below.

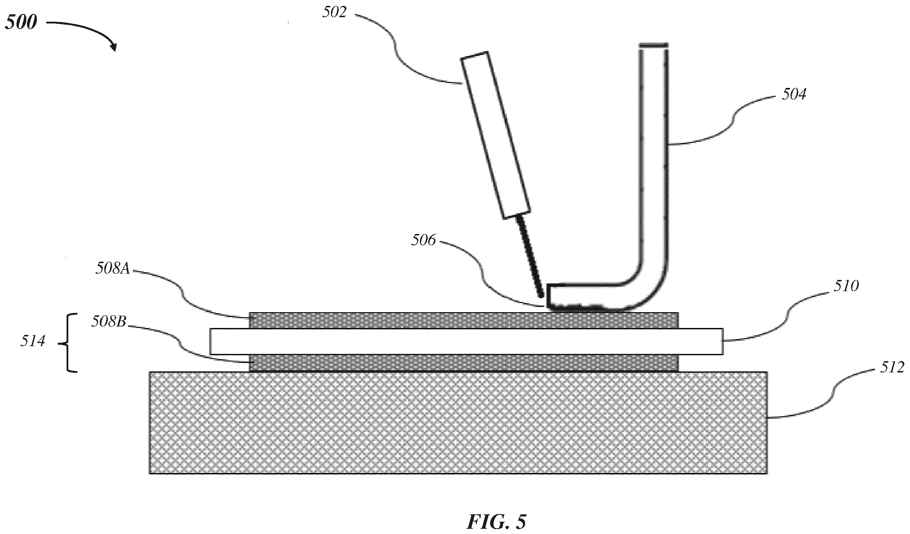

**FIG. 5** is a representative drawing of a laser bonding method 500 to connect a power terminal to a substrate within a semiconductor package, according to exemplary embodiments. A laser device 502 is used to connect a power terminal 504 to a substrate 514. Using the laser device 502, the laser bonding method 500 employs laser treatment to affix or bond the power terminal 504 to the substrate 514 in a manner sufficient to allow current to flow from the terminal to the substrate and vice-versa.

An interface 506 is shown between the power terminal 504 and the substrate 514. In an exemplary embodiment, the laser bonding method 500 involves attachment of the power terminal 504 to the substrate 514 by insertion of energy by way of the laser device 502, such that the power terminal is welded to the substrate. Within a relatively small area (the interface 506), the solid materials of the power terminal 504 and the substrate 514 are transformed (melted with consecutive rapid solidification), resulting in the weld connection. The interface 506 is meant to show the partial transformation (melting with consecutive rapid solidification) of each substance, that of the power terminal 504 and the substrate 514. Thus, the laser bonding method 500 heats up the power terminal 504 and the substrate 514, enabling the power terminal 504 to bond to the substrate 514. In one embodiment, both the power terminal 504 and the substrate 514 increase in temperature and transform (melt with consecutive rapid solidification), that is, each material reaches its melting temperature. The laser treatment described herein may also be referred to laser bonding.

In **FIG. 5****,** the substrate 514 is disposed on top of a baseplate 512 of the power semiconductor package. The baseplate 512 may be a heatsink such as in **FIGs. 1** or **3****.** The substrate 514 is shown as a sandwich structure consisting of two conducting materials 508A and 508B (collectively, "conducting materials 508") covering an insulating material 510. (It is actually the top layer conducting material 508A of the substrate 514 that is to be transformed (melted with consecutive rapid solidification) during the laser bonding process.) In an exemplary embodiment, the baseplate 512 consists of a metal heatsink. The substrate (direct copper bonded (DCB) material) is soldered or sintered to the metal heatsink. In one embodiment, the insulating material 510 is a thermal interface material (TIM) designed to enhance thermal coupling between the two covered conducting materials 508. In an exemplary embodiment, the insulating material 510 consists of aluminum oxide, aluminum nitride, or another kind of ceramic.

The sandwich structure of the substrate 514 may be formed from a variety of materials. In exemplary embodiments, the conducting materials 508 of the substrate 514 consist of a metal conducting material, such as copper, aluminum, or sintered copper paste. In an alternative embodiment, the substrate 514 consists of direct copper bonded (DCB) or direct bonded copper (DBC), direct aluminum bonded (DAB) or direct bonded aluminum (DBA) material. In another embodiment, the substrate 514 consists of an active metal brazed (AMB) substrate.

In exemplary embodiments, the power terminals consist of highly electrically conductive materials, such as copper or copper alloy, aluminum or aluminum alloy, or silver or silver alloy. Further, the power terminals may have plating of nickel, silver, or gold, which may be physically or chemically added to the surface. Power terminals for high power applications typically have a thickness of at least 0.8 mm, and may be as thick as 2.0 mm or more, as these terminals are designed to conduct high current, but the power terminals may vary in thickness from these values. Laser beam applications typically operate on materials that are not as thick as the typical power terminal. Lasers are high-energy beams, and the high energy is applied to the thin surface, within a very short time period, so as to melt, plus solidify (weld) materials. A laser beam for welding is not meant to cut through thick bars such as the power terminal 504, to weld the terminal to the interfaces underneath.

In **FIG. 5****,** the laser 502 is positioned at an angle near the bottom of a connecting portion of the power terminal 504. This enables the laser 502 to get close enough to the interface 506 so that both the top layer 508A of the substrate 514 and the power terminal 504 are in contact with the laser and transform (melt with consecutive rapid solidification). However, because the power terminal 504 is very thick, the laser 502 is positioned at an awkward angle so as to transform both a portion of the terminal and a portion of the top layer 508A of the substrate 514. In some cases, even with the laser 502 being positioned at an angle, melting the power terminal 504 is not guaranteed because the energy needed to melt the thick portion of the power terminal is higher than is readily supplied by the laser.

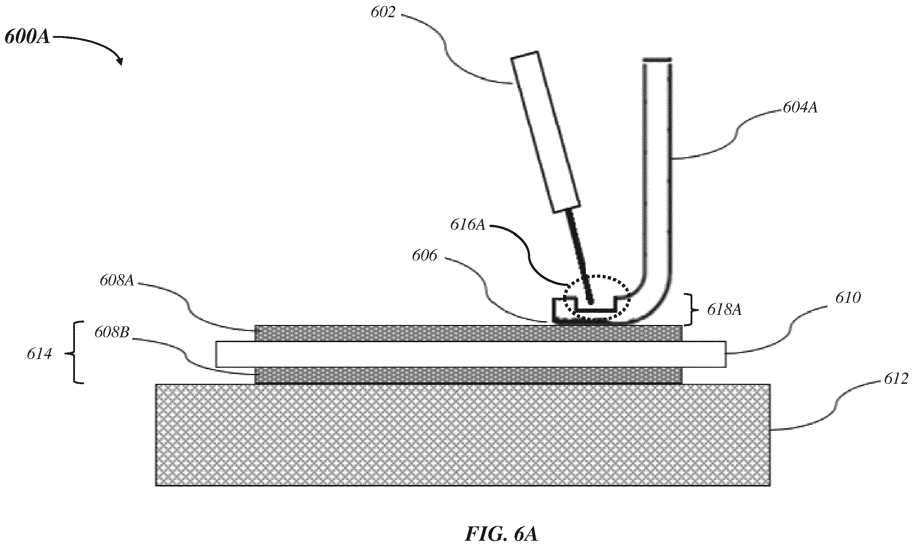

**FIGs. 6A-6F** are representative drawings of laser bonding methods 600A-600F (collectively, "laser bonding method 600") to connect a power terminal to a substrate, thus establishing an electrical connection therebetween, the substrate being disposed on a baseplate of a power semiconductor package, according to exemplary embodiments. The laser bonding method 600 is superior to the laser bonding method 500 of **FIG. 5** because the power terminal is strategically (partially) reduced in thickness at a first portion, with the rest of the power terminal remaining at its original thickness. In an exemplary embodiment, the first portion is near an edge of the power terminal. This ensures that the power terminal characteristics selected for the power semiconductor package, such as mechanical strength, electrical conductivity, and thermal management, are maintained.

**FIGs. 6A-6F** feature a laser device 602, respective power terminals 604A-F (collectively, "power terminal(s) 604"), interface 606, respective first portions of power terminals 618A-F (collectively, "first portion(s) 618"), and a substrate 614 disposed on top of a metal heatsink 612. The baseplate may be exposed direct copper bonded (DCB) or may include a heatsink, such as in **FIGs. 1-4****.** In an exemplary embodiment, the substrate 614 is a sandwich structure consisting of two conducting materials 608A and 608B (collectively, "conducting material(s) 608") covering an insulating material 610. In another embodiment, the substrate 614 is a DCB, DAB, or AMB (Active Metal Brazed) structure consisting of metal conducting material.

In contrast to the operation shown in **FIG. 5****,** the laser bonding method 600 modifies the power terminal to facilitate effective connection between terminal and substrate using laser bonding. Further, in an exemplary embodiment, the modification to the power terminal is minimal, as the portion of the power terminal disposed over the interface, the first portion 618A, is modified, with the remaining portion of the power terminal left untouched. Thus, in exemplary embodiments, the characteristics of the power terminal 604A, such as mechanical strength, electrical conductivity, and thermal management are maintained.

In **FIG. 6A****,** power terminal 604A has a modification in which a rectangular-shaped cutout 616A of first portion 618A of the power terminal is made. This reduces the thickness of the power terminal 604A, enabling the laser device 602 to transform (melt with consecutive rapid solidification) both the conducting material 608A of the substrate 614 and the power terminal 604A below the rectangular-shaped cutout 616A at the interface 606.

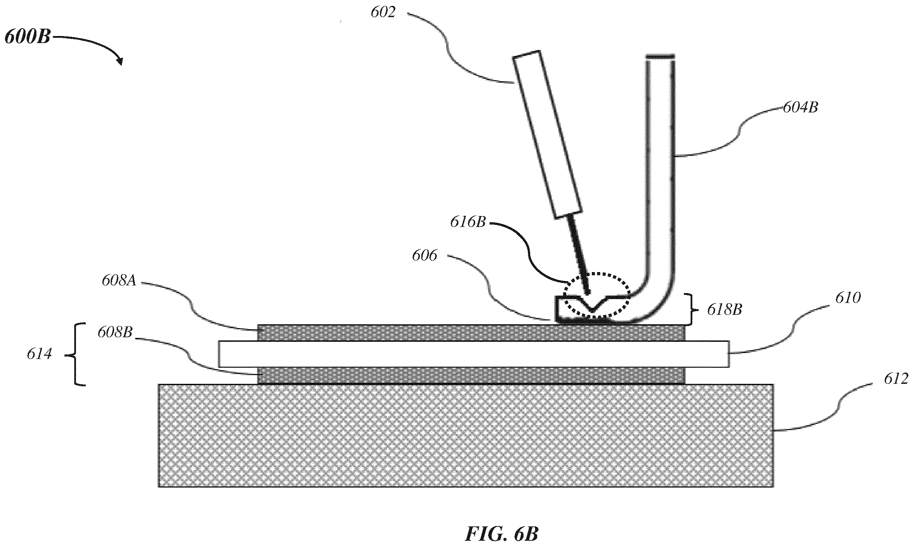

In **FIG. 6B****,** a power terminal 604B has a modification in which a V-shaped cutout 616B of first portion 618B of the power terminal is made. This reduces the thickness of the power terminal 604B, enabling the laser device 602 to transform (melt with consecutive rapid solidification) both the conducting material 608A of the substrate 614 and the power terminal 604B below the V-shaped cutout 616B at the interface 606.

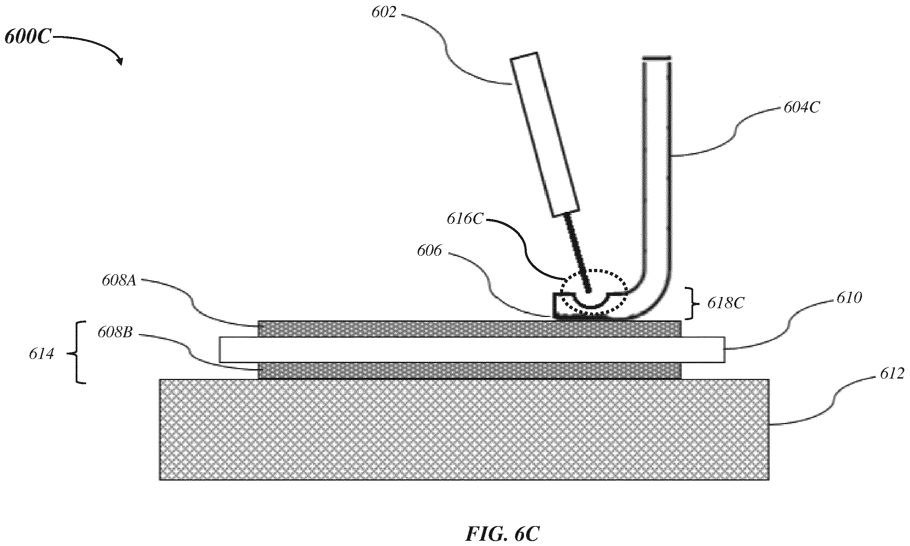

In **FIG. 6C****,** a power terminal 604C has a modification in which a U-shaped cutout 616C of first portion 618C of the power terminal is made. This reduces the thickness of the power terminal 604C, enabling the laser device 602 to transform (melt with consecutive rapid solidification) both the conducting material 608A of the substrate 614 and the power terminal 604C below the U-shaped cutout 616C at the interface 606.

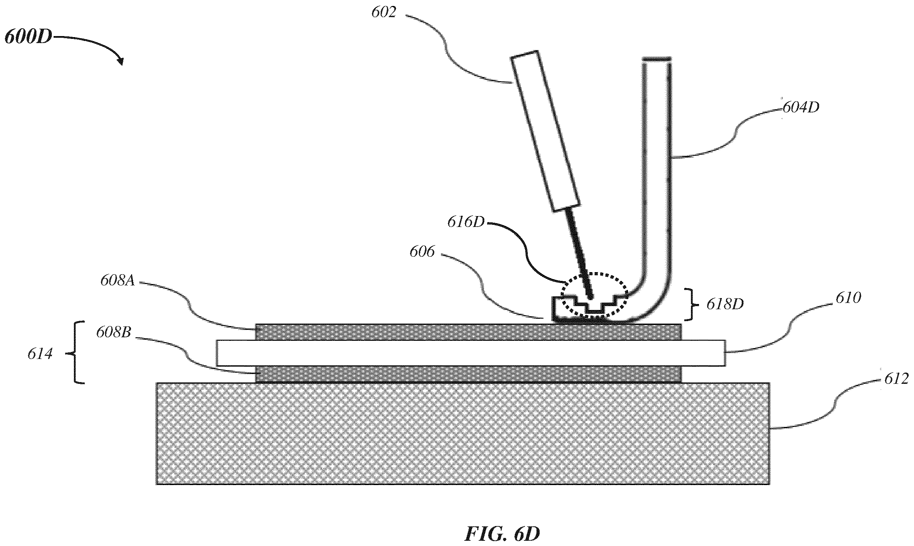

In **FIG. 6D****,** a power terminal 604D has a modification in which a stairstep-shaped cutout 616D of first portion 618D of the power terminal is made. This reduces the thickness of the power terminal 604D, enabling the laser device 602 to transform (melt with consecutive rapid solidification) both the conducting material 608A of the substrate 614 and the power terminal 604D below the stairstep-shaped cutout 616D at the interface 606.

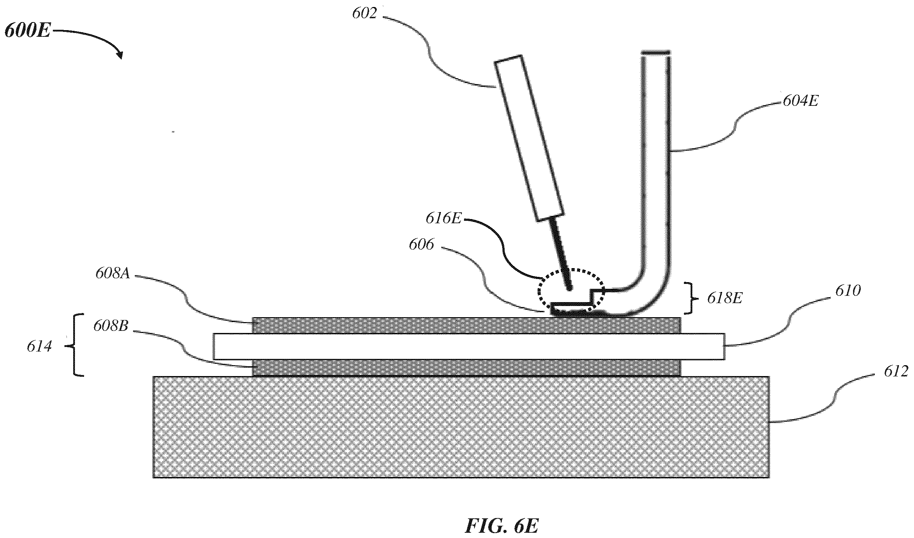

In **FIG. 6E****,** a power terminal 604E has a modification in which a cutout 616E forming a thin lip of the end portion 618E of the power terminal is made. This reduces the thickness of the power terminal 604E, enabling the laser device 602 to transform (melt with consecutive rapid solidification) both the conducting material 608A of the substrate 614 and the power terminal 604E below the cutout 616E at the interface 606.

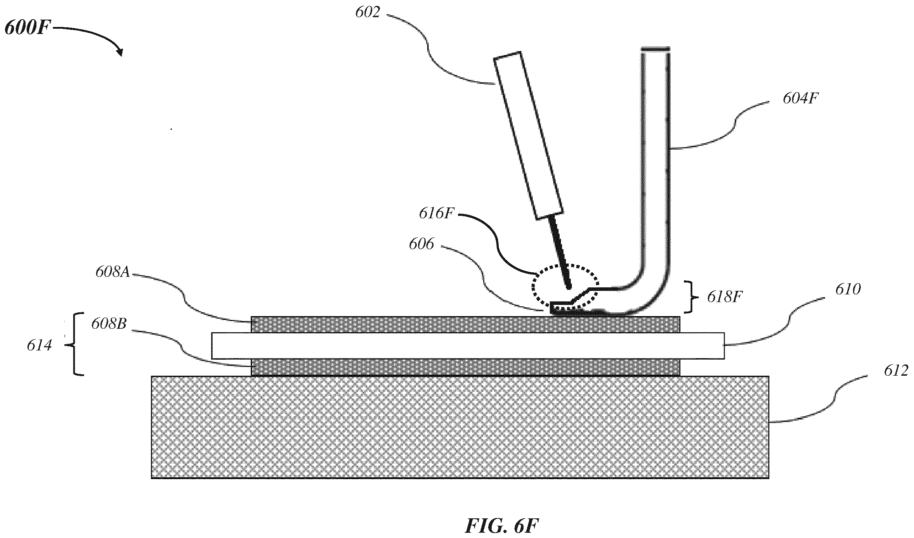

In **FIG. 6F****,** a power terminal 604F has a modification in which an angled cutout 616F forming an angled lip of the end portion 618F of the power terminal is made. This reduces the thickness of the power terminal 604F, enabling the laser device 602 to transform (melt with consecutive rapid solidification) both the conducting material 608A of the substrate 614 and the power terminal 604F below the angled shaped cutout 616F at the interface 606.

In exemplary embodiments, the laser bonding method 600 ensures that a contact is made between a top metal layer (e.g., conducting material 608A) of the insulated substrate 614 and the power terminal 604 using laser bonding technology. Laser bonding offers a stronger bond, higher reliability, and facilitates assembly steps, compared to other conventional technologies, such as ultrasonic welding. Ultrasonic welding, for example, is disadvantageous, as it may result in substrate cracking or debris generation. The electrical conductivity of the debris is also problematic.

In contrast to the configuration of **FIG. 5** in which the laser 502 is disposed at an angle between the power terminal 504 and the substrate 514, the laser 502 in **FIGs. 6A-6F** is able to be positioned over the first portion 618 of the power terminal. Because the first portion 618 is thinner than before, the laser device 602 is able to transform (melt with consecutive rapid solidification) both the power terminal 604 and the top layer conducting material 608A of the substrate 614 (indicated as interface 606), thus enabling a bond between the power terminal 604 and the substrate 614.

In the example illustrations 600A-600F, the common element is that the thickness of the power terminal 604 is reduced at first portion 618, which is the location above the respective interface 606, allowing the laser device 602 to perform transformation operations (melting with consecutive rapid solidification) that connect the power terminal to the substrate. Further, the power terminal 604 is minimally modified only at the region above the interface 606. The laser device 602 is able to be positioned directly over the power terminal 604 rather than being angled in between the power terminal and the substrate 614. Designers of ordinary skill in the art will recognize that there may be other modifications made to the first portion 618 of the power terminal 604. The laser device may come from the top going downward toward the power terminal, or may be angled as illustrated in **FIGs. 6A-6F****.**

In exemplary embodiments, the laser bonding method 600 is utilized on power semiconductor devices in which the substrate 614 and power terminal 604 are not disposed within a package or housing. In other embodiments, the laser bonding method 600 is utilized on power semiconductor devices which include housing or packaging, such as the examples given in **FIGs. 1-4****.** In still other embodiments, power terminals may be attached to the DCB before attaching the housing to the DCB (discrete transfer molded package). In other cases, the power terminal may be part of the housing, such as where the housing is produced by some injection molding process. The housing frame is then glued or bonded to the DCB, such as by using a glue, and the power terminals are connected to the DCB, such as by wire bonding or laser welding. The principles of the laser bonding method 600 shown and described herein may be implemented with a variety of different types of semiconductor packages.

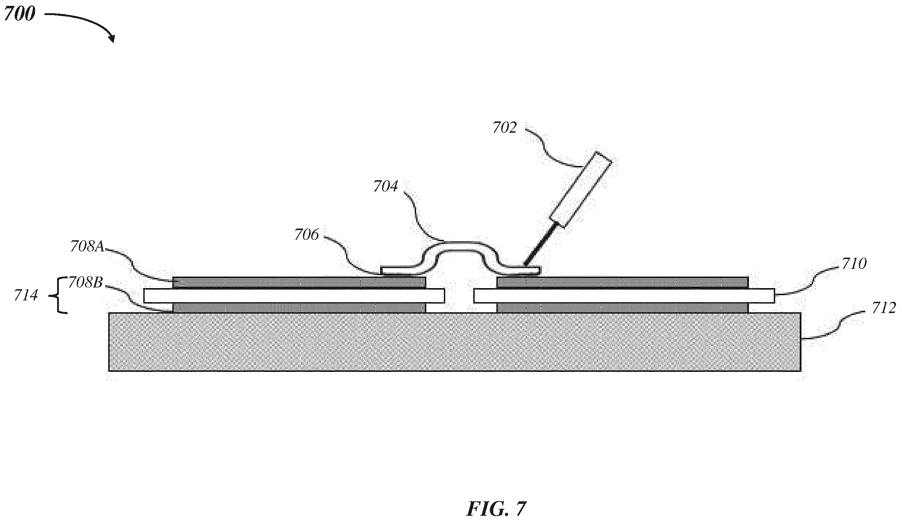

**FIG. 7** is a cross-sectional view of a partly assembled power module 700 consisting of a contact layer (substrate 714) and a contact element (known as a bridge clip 704) within a power semiconductor package, according to exemplary embodiments. The power module 700 also includes the substrate 714 consisting of two metal layers 708A and 708B, with insulating material 710 therebetween, which are disposed on a baseplate 712 or a supporting structure (such as a heatsink. A laser beam 702 is in position to weld the bridge clip 704 to the substrates 708. The bridge clip 704 is thin enough at the location of the interface 706 for laser bonding to transform (melt with consecutive rapid solidification) both the bridge clip and the top metal layer 708A, thus affixing the bridge clip to the substrate 714. As in the examples of **FIGs. 6A-6F****,** the bridge clip 704 may be modified at each end to render the modified portion thin enough to perform the laser bonding.

In exemplary embodiments, the laser bonding method may be used not only to connect to the power terminal, but may also be used to weld bridge clips, U-shaped terminals, V-shaped terminals, and terminals of virtually any shape. In either case, the laser bonding method enables connections between power terminals of many types and the substrates to which they are bonded.

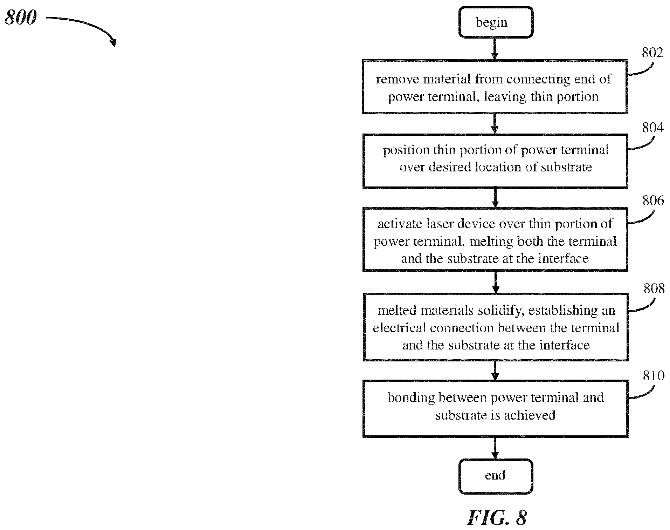

**FIG. 8** is a flow diagram 800 featuring operations performed by a laser bonding method, according to exemplary embodiments. Some material is removed from a connecting end (first portion) of a power terminal, such that a thin portion of material remains (block 802). The material may be removed by plastic deformation of the power terminal, such as pressing or rolling, or by removing material using processes such as grinding, milling, or cutting. Thus, following this operation, the first portion of the power terminal, from which some material has been removed, would be characterized as having a first dimension (thickness) while the rest of the power terminal, from which no material has been removed (second portion) has a second dimension, where the first dimension is less than the second dimension. The second dimension is, in fact, the original thickness of the power terminal. In an exemplary embodiment, the first portion dimension is less than or equal to 0.8 mm (typically between 0.2 mm and 0.8 mm) and the second dimension is between 0.8 mm and 5 mm. The thin (first) portion of the power terminal is positioned over the desired location of the substrate (block 804). The laser device is positioned over the thin (first) portion and activated, such that both the terminal and the substrate are transformed (melted with consecutive rapid solidification) (block 806). Once the two transformed materials solidify, an electrical connection is established between the terminal and the substrate at the interface (block 808). A bond is thus completed between the power terminal and the substrate (block 810).

The laser bonding method disclosed herein may be used in power semiconductors, direct copper bond (DCB) substrate technology and other high voltage packaging. In exemplary embodiments, the laser bonding method is used to automate manual substrate to leadframe soldering processes as well as leadframe plus substrate loading into standard die attach equipment, as these processes traditionally employed soldering. Further, the laser bonding method has the potential to reduce costs to manufacturers of power modules, power semiconductors, DCB substrate technology, and high voltage packaging.

As used herein, an element or step recited in the singular and proceeded with the word "a" or "an" should be understood as not excluding plural elements or steps, unless such exclusion is explicitly recited. Furthermore, references to "one embodiment" of the present disclosure are not intended to be interpreted as excluding the existence of additional embodiments that also incorporate the recited features.

While the present disclosure makes reference to certain embodiments, numerous modifications, alterations and changes to the described embodiments are possible without departing from the sphere and scope of the present disclosure, as defined in the appended claim(s). Accordingly, it is intended that the present disclosure not be limited to the described embodiments, but that it has the full scope defined by the language of the following claims, and equivalents thereof.

## Claims

1. A laser bonding method, comprising:
removing material from a first portion of a power terminal such that the first portion has a first dimension and a second portion of the power terminal has a second dimension, wherein the first dimension is less than the second dimension;
disposing the first portion over a substrate of a semiconductor device;
activating a laser device at an interface between the first portion and the substrate; and
connecting the first portion of the power terminal to the substrate.

2. The laser bonding method of claim 1, removing material from the first portion further comprising forming a cutout of the first portion.

3. The laser bonding method of claim 2, wherein the cutout of the first portion is selected from a group consisting of rectangular-shaped, V-shaped, U-shaped, and stairstep-shaped.

4. The laser bonding method of any of claims 1-3, removing material from the first portion further comprising forming a lip of the first portion.

5. The laser bonding method of any of claims 1-4, removing material from the first portion further comprising forming an angled lip of the first portion.

6. The laser bonding method of any of claims 1-5, removing material from the first portion further comprising reducing the first portion until the first dimension is between 0.2 mm and 0.8 mm.

7. The laser bonding method of any of claims 1-6, wherein the substrate comprises two conducting materials covering an insulating material.

8. The laser bonding method of claim 7, wherein the two conducting materials comprise copper, aluminum, or sintered copper paste.

9. The laser bonding method of claim 7, wherein the insulating material comprises aluminum oxide, aluminum nitride, silicon nitride, or other ceramic.

10. The laser bonding method of any of claims 1-9, wherein the substrate comprises direct copper bonded material or direct aluminum bonded material.

11. A power semiconductor package comprising:
a substrate comprising an insulator material sandwiched between a first conducting material and a second conducting material, wherein the substrate is disposed on a baseplate; and
a power terminal disposed on the first conducting material, the power terminal comprising:
a first portion having a first dimension; and
a second portion having a second dimension, the first dimension being smaller than the second dimension, wherein the first portion is disposed adjacent to the first conducting material at an interface;
wherein the first portion and the first conducting material are transformed at the interface using a laser device such that, once the transformed first portion and first conducting material solidify, an electrical connection is established between the first conducting material and the power terminal.

12. The power semiconductor package of claim 12, further comprising a heatsink and the heatsink comprises an exposed direct copper bond.

13. The power semiconductor package of claim 11 or 12, wherein the first dimension of the first portion is generated by either plastic deformation or material removal.

14. The power semiconductor package of any of claims 11-13, the power terminal further comprising mechanical strength, electrical conductivity, and thermal management characteristics, wherein the first portion does not diminish the mechanical strength, electrical conductivity, and thermal management characteristics of the power terminal.

15. The power semiconductor package of any of claims 11-14, wherein the first portion is selected from a group consisting of rectangle-shaped, U-shaped, V-shaped, stairstep-shaped, lip-shaped, angled, and a combination of one or more of rectangular-shaped, U-shaped, V-shaped, stairstep-shaped, lip-shaped, and angled.
